# EUROPEAN PATENT APPLICATION

(11) **EP 4 845 350 A1**
(43) Date of publication of application: **25.11.2026**
(21) Application number: 25853413.0
(22) Date of filing: 12.03.2025
(51) Int. Cl.: H10F 19/90, H10F 77/20

(54) **SOLAR CELL, PHOTOVOLTAIC MODULE, AND PHOTOVOLTAIC SYSTEM**

(30) Priority: 13.08.2024 CN 202421960661 U
(71) Applicant: Zhuhai Fushan Aiko Solar Energy Technology Co., Ltd., FushanIndustrial Park, Doumen District Zhuhai Guangdong 519000 (CN); Shenzhen Aiko Digital Energy Technology Co., Ltd., Shenzhen, Guangdong 518000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Zhejiang Aiko Solar Energy Technology Co., Ltd., Yiwu, Jinhua Zhejiang 322000 (CN); Chuzhou Aiko Solar Technology Co., Ltd., Chuzhou, Anhui 239514 (CN); Shandong Aiko Solar Energy Technology Co., Ltd., Jinan, Shandong 250000 (CN)
(72) Inventor: SONG, Banghao, Jinhua, Zhejiang 322000 (CN); XING, Jianchong, Jinhua, Zhejiang 322000 (CN); DING, Sen, Jinhua, Zhejiang 322000 (CN); CHEN, Gang, Jinhua, Zhejiang 322000 (CN)
(74) Representative: EP&C
(86) International application number: PCT/CN2025/082217
(87) International publication number: WO 2026/036707

(57) **Abstract**

The present disclosure is applicable to the technical field of solar power generation, and provides a solar cell, a photovoltaic module and a photovoltaic system; the solar cell includes a silicon substrate, a doped layer and a passivation layer, the doped layer is provided on at least one of a front surface and a back surface of the silicon substrate; a passivation layer is provided on a side surface of the doped layer away from the silicon substrate; and several grooves are provided on a back surface of a back contact solar cell; positions where the grooves are located do not include the passivation layer; and a central region at a bottom of the groove is provided with several first synaptic structures connected to the doped layer. By forming the first synaptic structures in the central region at the bottom of the grooves, when a metal grid line is printed subsequently, a good ohmic contact can be formed between the metal grid line and the first synaptic structures, thereby improving the carrier collection efficiency and improving the conversion efficiency of the cell.

## Description

### Cross-Reference to Related Application

The present disclosure claims the priority of Chinese Patent Application no. 202421960661.4, filed to the China National Intellectual Property Administration on 13 August 2024 and entitled "Solar Cell, Photovoltaic Module and Photovoltaic System", the disclosure of which is incorporated herein by reference in its entirety.

### Technical Field

The present disclosure relates to the technical field of solar power generation, and in particular, to a solar cell, a photovoltaic module, and a photovoltaic system.

### Background

A solar cell is a device for directly converting light energy into electric energy by means of a photoelectric effect or a photochemical effect, in which back contact (BC) cell is a general term for various crystalline silicon solar cells with a back contact structure, including an HPBC, a TBC, an HBC, etc. The back contact of the BC cell means that the emitter electrode and the base electrode are both located on the back surface, and the back contact cell structure, on the one hand, transfers the emitter electrode to the back surface of the cell, thereby reducing or eliminating the shading loss of the front grid lines and improving the cell efficiency; on the other hand, the module is easy to assemble when the module is packaged, and since all the electrodes are on the back surface, the distance between the cells can be reduced, thereby improving the packaging density, and providing an aesthetics appearance.

BC cells require laser film opening and printing of metal grid lines to collect carriers. However, currently, the grid line printing for BC cells on the market cannot form a good ohmic contact, reducing the probability of carrier collection and thus leading to a decrease in conversion efficiency.

### Summary

Embodiments of the present disclosure provide a solar cell, which is intended to solve the problem that the existing solar cells have a low collection efficiency of carriers, and thus the conversion efficiency is reduced.

Embodiments of the present disclosure are implemented as follows: a solar cell, including a silicon substrate, a doped layer and a passivation layer, where the doped layer is provided on at least one of a front surface and a back surface of the silicon substrate; a passivation layer is provided on a side surface of the doped layer away from the silicon substrate; and several grooves are provided on a back surface of a back contact solar cell; positions where the grooves are located do not include the passivation layer; and a central region at a bottom of the grooves is provided with the several first synaptic structures connected to the doped layer.

Further, an edge region located at a periphery of the central region is provided at the bottom of the groove; and the edge region is provided with several second synaptic structures.

Further, the edge region is higher than the central region in a direction from the silicon substrate to the doped layer.

Further, several first districts are provided in the central region; and at least some first synaptic structures at boundaries between adjacent first districts have a height higher than that of the first synaptic structures in the first district.

Further, the central region includes a boundary of a tower base of a micro-pyramid structure; and at least some first synaptic structures at the boundary have a height higher than that of rest of the first synaptic structures.

Further, the edge region of the groove extends away from the central region to form a gap space between the doped layer and the passivation layer.

Further, aside surface of the passivation layer facing the gap space is provided with several third synaptic structures.

Further, several fourth synaptic structures are provided in the gap space; and two ends of the fourth synaptic structure are respectively connected to the doped layer and the passivation layer.

Further, shapes of the first synaptic structure, the second synaptic structure, and the third synaptic structure include at least one of a dome-shaped protrusion, a sharp tip, a spherical shape, a conical shape, and an irregular shape.

Further, a maximum distance between any two points on a bottom profile of the first synaptic structure, the second synaptic structure, and the third synaptic structure is less than 500 nm.

Further, heights of the first synaptic structure, the second synaptic structure, and the third synaptic structure are less than 500 nm.

Further, a diameter of the groove is 12 micrometers to 30 micrometers.

In a second aspect, the present disclosure further provides a photovoltaic module, including the described solar cell.

In a third aspect, the present disclosure further provides a photovoltaic system, including the described photovoltaic module.

The beneficial effects of the present disclosure are that the back contact solar cell of the present disclosure includes the silicon substrate, the doped layer and the passivation layer, where the doped layer is provided on the back surface of the silicon substrate; the passivation layer is provided on the side surface of the doped layer away from the silicon substrate; and several grooves are provided on the back surface of the back contact solar cell; the positions where the grooves are located do not include the passivation layer; and the central region at the bottom of the groove is provided with several first synaptic structures connected to the doped layer. By forming the first synaptic structures in the central region at the bottom of the groove, when metal grid lines are printed subsequently, a good ohmic contact can be formed between the metal grid lines and the first synaptic structures, thereby improving the carrier collection efficiency and improving the conversion efficiency of the cell.

### Brief Description of the Drawings

Fig. 1 is a schematic diagram of a layer structure after laser film opening of according to an embodiment of the solar cell of the present disclosure.
Fig. 2 is a schematic structural diagram after laser film opening according to an embodiment of the solar cell of the present disclosure;
Fig. 3 is a schematic structural diagram of a groove according to an embodiment of the solar cell of the present disclosure;
Fig. 4 is a schematic diagram of first synaptic structures according to an embodiment of the solar cell of the present disclosure;
Fig. 5 is a schematic sectional diagram of a groove according to an embodiment of the solar cell of the present disclosure;
Fig. 6 is a schematic structural diagram of a gap space according to an embodiment of the solar cell of the present disclosure;
Fig. 7 is a schematic diagram of an internal interface of a groove according to an embodiment of the solar cell of the present disclosure;
Fig. 8 is a structural schematic diagram of a groove with a further recessed bottom according to an embodiment of the solar cell of the present disclosure;
Fig. 9 is a structural schematic diagram of a groove internally provided with first districts according to an embodiment of the solar cell of the present disclosure;
Fig. 10 is a schematic diagram of a boundary of a tower base of a pyramid within the groove according to an embodiment of the solar cell of the present disclosure.

### Detailed Description of the Embodiments

To make the objectives, technical solutions, and advantages of the present disclosure clearer, the present disclosure is further described in details below in combination with the drawings and embodiments. Examples of the embodiments will be illustrated in the accompanying drawings, where throughout the description, same or similar reference numerals represent same or similar elements or elements with same or similar functions. The embodiments described below with reference to the accompanying drawings are illustrative, and are intended to illustrate the present disclosure, and shall not be understood as limiting the present disclosure. In addition, it should be understood that the specific embodiments described herein are only used to explain the present disclosure, and are not intended to limit the present disclosure.

In the description of the present disclosure, it should be understood that, orientations or position relationships indicated by terms such as "length", "width", "upper", "lower", "left", "right", "horizontal", "top", "bottom" and the like are orientations or position relationships based on accompanying drawings and are only for the convenience of illustration of the specification and simplicity of illustration, rather than explicitly or implicitly indicate that apparatuses or components referred to herein must have a certain direction or be configured or operated in a certain direction and therefore cannot be understood as limitations to the present disclosure.

In addition, the terms "first" and "second" are only used for descriptive purposes, and cannot be understood as indicating or implying relative importance or implicitly indicating the number of indicated technical features. Thus, features defined by "first" and "second" may explicitly or implicitly include one or more of the features. In the description of the present disclosure, "a plurality of" refers to two or more than two, unless specified otherwise.

In the description of the present disclosure, it should be noted that, unless otherwise specified or defined, the terms such as "mount", "connected" and "connection" should be understood in a broad sense, for example, the connection may be a fixed connection, or a detachable connection, or an integral connection; may be a mechanical connection, may also be an electrical connection or may be an intercommunication; and may be a direct connection, an indirect connection through a medium, or a communication connection between two components or an interaction connection between two components. For those of ordinary skill in the art, the specific meanings of the above terms in the present disclosure can be understood according to specific situations.

In the present disclosure, unless specified or limited otherwise, a first feature being "above" or "below" a second feature may include a direct contact between the first feature and the second feature, and may also include another feature contact between the first feature and the second feature rather than a direct contact. In addition, the first feature being "above", "over", and "on" the second feature includes the first feature being right above and obliquely above the second feature or only refers to the first feature being at a higher horizontal level than the second feature. The first feature being "below", "underneath", and "under" the second feature includes the first feature being right below and obliquely below the second feature or only refers to the first feature being at a lower horizontal level than the second feature.

The following disclosure provides many different embodiments or examples for implementing different structures of the present disclosure. In order to simplify the disclosure of the present disclosure, components and settings of specific examples are described below. Of course, they are merely examples and are not intended to limit the present disclosure. Furthermore, the present disclosure may repeat reference numerals and/or reference letters in different examples for the purpose of simplicity and clarity, and does not in itself indicate a relationship between the various embodiments and/or arrangements discussed. In addition, the present disclosure provides examples of various specific processes and materials, but those skilled in the art will recognize the application of other processes and/or the use of other materials.

A back contact solar cell of the present disclosure includes a silicon substrate, a doped layer and a passivation layer, where the doped layer is provided on a back surface of the silicon substrate; a passivation layer is provided on a side surface of the doped layer away from the silicon substrate; and several grooves are provided on a back surface of the back contact solar cell; positions where the grooves are located do not include the passivation layer; and a central region at a bottom of the groove is provided with several first synaptic structures connected to the doped layer. By forming the first synaptic structures in the central region at the bottom of the groove, when a metal grid line is printed subsequently, a good ohmic contact can be formed between the metal grid line and the first synaptic structures, thereby improving the carrier collection efficiency and improving the conversion efficiency of the cell.

### Embodiment I

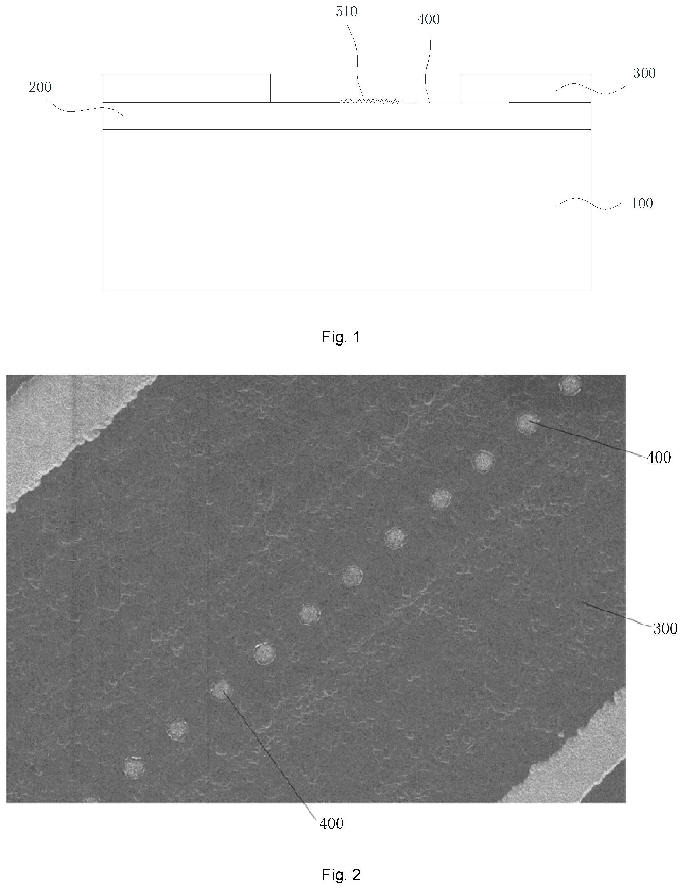

As shown in Fig. 1 to Fig. 10, one embodiment of the present disclosure provides a back contact solar cell, including a silicon substrate 100, a doped layer 200 and a passivation layer 300, where the doped layer 200 is provided on a back surface of the silicon substrate 100; the passivation layer 300 is provided on a side surface of the doped layer 200 away from the silicon substrate 100; and several grooves 400 are provided on a back surface of the back contact solar cell; positions where the grooves 400 are located do not include a passivation layer, that is, the grooves 400 penetrate through the passivation layer 300; and a central region 410 at a bottom of the groove 400 is provided with several first synaptic structures 510 connected to the doped layer 200.

The silicon substrate 100 refers to a base material for manufacturing a semiconductor device, and is generally a monocrystalline or polycrystalline material manufactured by a highly purified and crystal growth technology, which is not described in detail herein.

Optionally, the silicon substrate 100 may be an N-type silicon wafer or a P-type silicon wafer, where the N-type silicon wafer is obtained by adding a pentavalent element (such as phosphorus) into a monocrystalline or polycrystalline material, and the P-type silicon wafer is obtained by adding a trivalent element (such as boron, gallium or indium) into a monocrystalline or polycrystalline material, which will not be described in detail herein.

The silicon substrate 100 has a front surface and a back surface, where the front surface of the silicon substrate 100 corresponds to a light receiving surface of the solar cell, and likewise, the back surface of the silicon substrate 100 corresponds to a backlight surface of the solar cell.

The doped layer 200 and the passivation layer 300 are sequentially laminated on the back surface of the silicon substrate 100. In some embodiments, the doped layer 200 is formed by further doping trivalent elements or pentavalent elements on the basis of the silicon substrate 100. Exemplarily, taking the silicon substrate 100 being an N-type silicon wafer as an example, an emitter doped layer 200 is obtained by doping a trivalent element on the basis of the N-type silicon wafer, and in this case, the emitter doped layer 200 may be regarded as a p+ layer; likewise, a diffusion doped layer 200 is obtained by doping a pentavalent element on the basis of the N-type silicon wafer, and in this case, the diffusion doped layer 200 may be regarded as an n+ layer.

During implementation, the passivation layer 300 is provided on the doped layer 200, and the passivation layer 300 refers to a layer of thin film that passivates or renders the surface of the cell inactive. The passivation layer 300 is generally composed of at least one of silicon nitride, aluminum oxide, silicon oxynitride and silicon oxide, so as to reduce the activity of the surface of the cell, thereby reducing the surface recombination rate.

Optionally, the passivation layer 300 may be manufactured by means of plasma enhanced chemical vapor deposition (PECVD) or may be manufactured by means of low pressure chemical vapor deposition (LPCVD), which will not be described in detail herein.

On the basis that the doped layer 200 and the passivation layer 300 have been manufactured, it is necessary to use a laser to open the passivation layer 300. For example, a picosecond laser or a femtosecond laser can be used to open the passivation layer. The laser irradiates the target position on the passivation layer 300, causing the passivation layer 300 at the target position to undergo instantaneous vaporization and subsequent re-solidification under the action of a high-temperature laser spot. That is to say, the grooves 400 are formed on the passivation layer 300 by means of laser film opening, as shown in Fig. 2, several grooves 400 are provided on the back surface of the back contact solar cell, and the passivation layer 300 is not provided at the positions where the grooves 400 are located.

Optionally, the diameter of the groove 400 is in a range of 12 micrometers to 30 micrometers, for example, 13 nanometers, 14 nanometers, 15 nanometers, 18 nanometers, 20 nanometers, 25 nanometers, 27 nanometers, 29 nanometers, or any value in the range of 12 micrometers to 30 micrometers, which is not limited herein.

A central region 410 at the bottom of the groove 400 is provided with several first synaptic structures 510. As shown in Fig. 1, the first synaptic structure 510 is a protrusion, such as a columnar protrusion and a conical protrusion, connected to the doped layer 200. The first synaptic structures 510 are formed by the doped layer 200 under the action of a high-temperature laser spot during laser film opening, which will not be described in detail herein.

The first synaptic structure 510 is a protrusion structure, and when metal grid lines are printed subsequently, the metal grid lines are in contact with and bonded to the first synaptic structures 510, thereby forming a good ohmic contact.

Optionally, a length of a bottom of the first synaptic structure 510 is less than 500 nm, for example, when the synaptic structure is a dome-shaped protrusion or a conical protrusion, the diameter of the bottom of the synaptic structure may be 5 nanometers, 6 nanometers, 7 nanometers, 10 nanometers, 15 nanometers, 20 nanometers, 50 nanometers, 100 nanometers, 200 nanometers, 400 nanometers, or any value less than 500 nanometers, which is not limited herein.

In some embodiments, a height of the first synaptic structure 510 may be less than 500 nanometers, such as any of 5 nanometers, 6 nanometers, 7 nanometers, 10 nanometers, 15 nanometers, 20 nanometers, 25 nanometers, 30 nanometers, 50 nanometers, 100 nanometers, 200 nanometers, 400 nanometers, or any value less than 500 nanometers, which is not limited herein.

The back contact solar cell of the present disclosure includes the silicon substrate 100, the doped layer 200 and the passivation layer 300, where the doped layer 200 is provided on the back surface of the silicon substrate 100; the passivation layer 300 is provided on the side surface of the doped layer 200 away from the silicon substrate 100; and several grooves 400 are provided on the back surface of the back contact solar cell; the positions where the grooves 400 are located do not include the passivation layer 300; and the central region 410 at the bottom of the groove 400 is provided with several first synaptic structures 510 connected to the doped layer 200. By forming the first synaptic structures 510 in the central region 410 at the bottom of the grooves 400, when metal grid lines are printed subsequently, a good ohmic contact can be formed between the metal grid lines and the first synaptic structures 510, thereby improving the carrier collection efficiency and improving the conversion efficiency of the cell.

As a manner, in order to observe the synaptic structure, for example, to facilitate observation of the first synaptic structures 510, the electrode on the finished solar cell may be washed away.

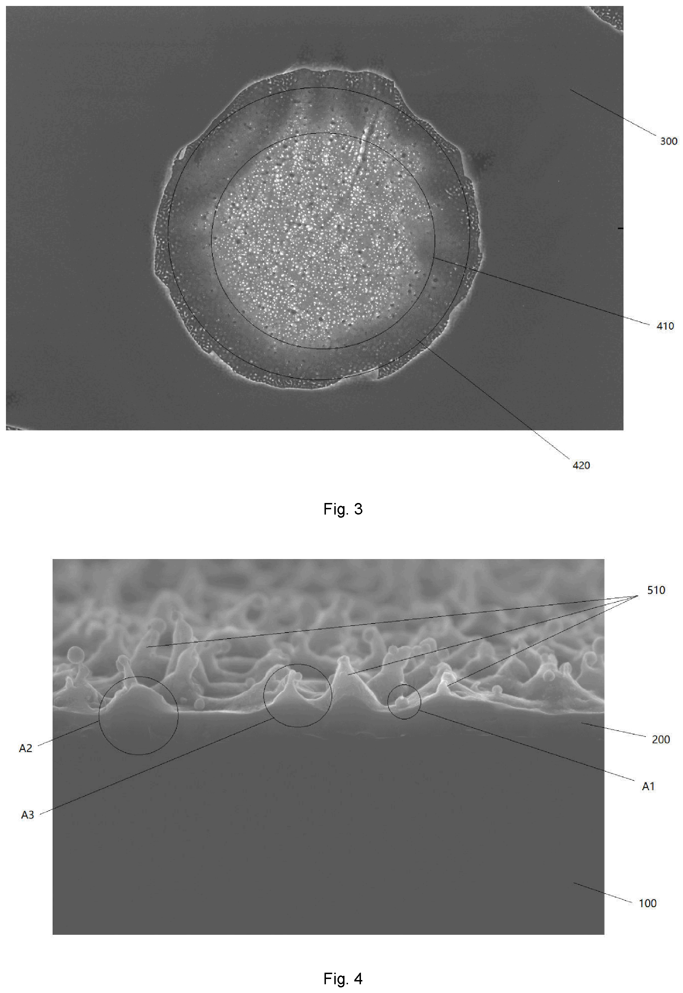

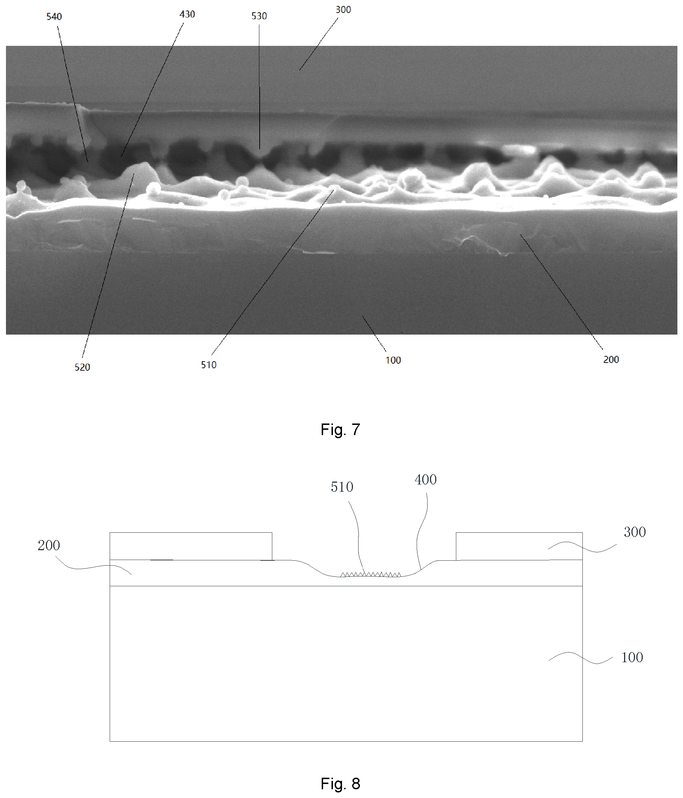

In some optional embodiments, as shown in Figs. 3 and 7, the bottom of the groove 400 is provided with an edge region 420 at a periphery of the central region 410, and the edge region 420 is provided with several second synaptic structures 520.

The bottom of the groove 400 may be divided into a central region 410 of the middle portion, and an edge region 420 located at the periphery of the central region 410. Exemplarily, the central region 410 may be regarded as an inner circle at the bottom of the groove 400, and the edge region 420 may be regarded as an outer ring at the bottom of the groove 400. The edge region 420 is provided with several second synaptic structures 520, and the second synaptic structures 520 can increase the roughness of the bottom of the groove 400, so as to better combine with the metal grid lines, so that the contact between the metal grid lines and the second synaptic structures 520 is more stable, and the grid line electrode is not easily detached.

As a possible manner, in a direction facing away from the silicon substrate 100, the edge region 420 is higher than the central region 410, that is to say, the bottom of the groove 400 may be further recessed, as shown in Fig. 8, so as to further improve the contact effect with the electrode.

Optionally, several first districts 411 are provided in the central region 410; and at least some first synaptic structures 510 at boundaries between adjacent first districts 411 have a height higher than that of the first synaptic structures 510 in the first district 411.

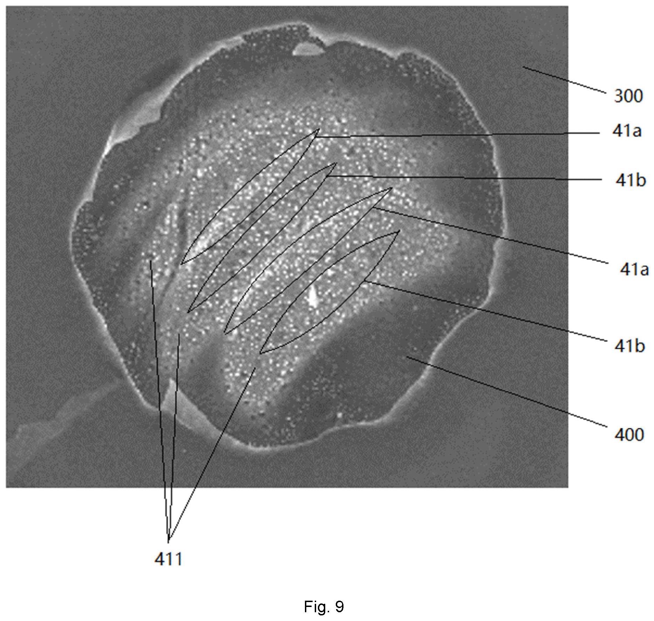

The central region 410 may be divided into several first regions 411, at least some first synaptic structures 510 at the boundaries between adjacent first regions 411 have a higher height, as shown in Fig. 9, 41a is first synaptic structures 510 at the boundary between adjacent first region 411; 41b is first synaptic structures 510 in the first district 411; some or all of the first synaptic structures 510 of 41a have a height higher than that of the first synaptic structures 510 of 41b; and when an electrode is printed subsequently, the electrode is connected to the doped layer 200 more stably, and the electrical conductivity is better.

In some possible embodiments, along a direction from an edge of the central region 410 to a central point of the central region 410, the height of the first synaptic structures 510 gradually increases, or along the direction from the edge of the central region 410 to the central point of the central region 410, the height of the first synaptic structures 510 increases in stages, which is not limited herein.

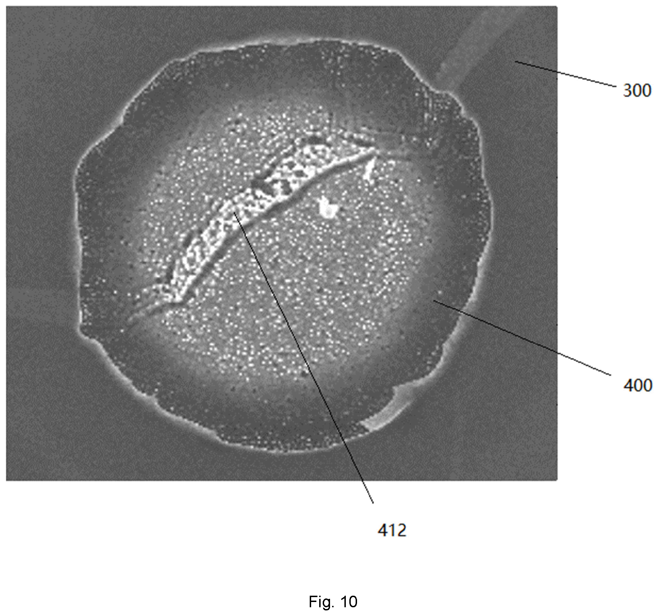

Further, the central region 410 includes a boundary 412 of a tower base of a micro-pyramid structure, and as shown in Fig. 10, at least some first synaptic structures 510 at the boundary 412 has a height higher than that of the rest of the first synaptic structures 510.

The micro-pyramid structure refers to dense micro-protrusions formed on a doped region. Generally, these micro-protrusions are in the shape of a pyramid. As a possible implementation, the tips of these micro-protrusions in the shape of a pyramid may be removed, leaving the tower bases. During laser film opening, some or all of the first synaptic structures 510 formed at the boundary of the tower base are higher than the rest of the first synaptic structures 510 in the groove 400, so as to improve the contact effect with the electrode.

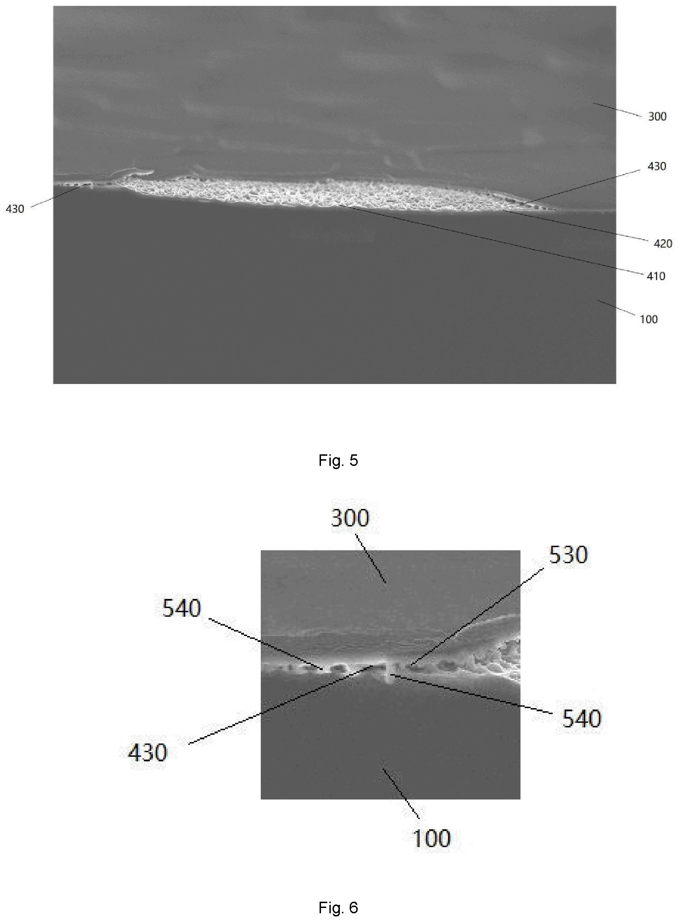

In some optional embodiments, as shown in Fig. 6, during laser film opening, the laser spot causes delamination between the doped layer 200 and the passivation layer 300 around the groove 400, whereby the edge region 420 extends away from the central region 410, forming a gap space 430 between the doped layer 200 and the passivation layer 300. When the metal grid lines are printed subsequently, a metal slurry can penetrate into the gap space 430, so that the metal grid lines formed after curing are more stably connected to the cells.

In some embodiments, a side surface of the passivation layer 300 facing the gap space 430 is provided with several third synaptic structures 530; in the gap space 430, the passivation layer 300 is provided with the third synaptic structures 530; when metal grid lines are subsequently printed, a metal slurry penetrates into the gap space 430, and is in contact with and bonded to the third synaptic structures 530, thereby further improving the stability of connection between the metal grid line and a cell.

In some optional embodiments, several fourth synaptic structures 540 are provided in the gap space 430, two ends of the fourth synaptic structure 540 are respectively connected to the doped layer 200 and the passivation layer 300; and the fourth synaptic structure 540 may be regarded as a connection column for connecting the doped layer 200 and the passivation layer 300, so that subsequently printed metal grid lines are connected to the solar cell more stably.

Optionally, shapes of the first synaptic structure 510, the second synaptic structure 520, and the third synaptic structure 530 include at least one of a dome-shaped protrusion, a sharp tip, a spherical shape, a conical shape, and an irregular shape. Each synaptic structure may be a dome-shaped protrusion, as shown in A2 of Fig. 4. The synaptic structure may also be a spherical structure, as shown in A1 of Fig. 4. The synaptic structure may also be a conical structure, as shown in A3 of Fig. 4. In some possible embodiments, each synaptic structure may also be a combination of structures of various shapes, for example, each synaptic structure may include a dome and a spherical structure at a top of the dome, or each synaptic structure may include a cone and a spherical structure at a top of the cone.

Optionally, for the shape structure, size, and height of the second synaptic structure 520 and the third synaptic structure 530, reference may be made to the first synaptic structure 510, which will not be described in detail herein.

### Embodiment II

In some optional embodiments, the present disclosure further provides a photovoltaic module, including the described solar cell.

A person skilled in the art would have been able to clearly understand that, for the purpose of convenient and brief description, for the structure and implementation principle of the photovoltaic module that are described above, reference may be made to the corresponding structure and implementation principle in Embodiment I, and it will not be described in detail herein.

The back contact solar cell of the present disclosure includes a silicon substrate 100, a doped layer 200 and a passivation layer 300, where the doped layer 200 is provided on the back surface of the silicon substrate 100; a passivation layer 300 is provided on the side surface of the doped layer 200 away from the silicon substrate 100; and a plurality of grooves 400 are provided on a back surface of a back contact solar cell; positions where the grooves 400 are located do not include the passivation layer 300; and a central region 410 at a bottom of the groove 400 is provided with several first synaptic structures 510 connected to the doped layer 200. By forming the first synaptic structures 510 in the central region 410 at the bottom of the grooves 400, when metal grid lines are printed subsequently, a good ohmic contact can be formed between the metal grid lines and the first synaptic structures 510, thereby improving the carrier collection efficiency and improving the conversion efficiency of the cell.

### Embodiment III

In some optional embodiments, the present disclosure further provides a photovoltaic system, including the described photovoltaic module.

During implementation, the photovoltaic system may be applied in a photovoltaic power plant, such as a surface power station, a rooftop power plant and a floating power plant, and may also be applied to a device or an apparatus that generates power using solar energy, such as a solar power source, a solar street lamp, a solar-powered vehicle, and a solar building. Certainly, it can be understood that, the application scenarios of the photovoltaic system are not limited thereto, that is, the photovoltaic system may be applied in all fields that need to use solar energy to generate power. Taking a photovoltaic power generation system network as an example, the photovoltaic system may include a photovoltaic array, a combiner box and an inverter; the photovoltaic array may be an array combination of a plurality of photovoltaic modules, for example, the plurality of photovoltaic modules may form a plurality of photovoltaic arrays, the photovoltaic arrays are connected to the combiner box; and the combiner box may collect currents generated by the photovoltaic arrays, and the collected currents are converted by the inverter into an alternating current required by the utility grid, and then are connected to the utility grid to implement solar power supply.

A person skilled in the art would have been able to clearly understand that, for the purpose of convenient and brief description, for the structure and implementation principle of the photovoltaic system that are described above, reference may be made to the corresponding structure and implementation principle in Embodiments I and II, and details are not described herein again.

The back contact solar cell of the present disclosure includes a silicon substrate 100, a doped layer 200 and a passivation layer 300, where the doped layer 200 is provided on the back surface of the silicon substrate 100; a passivation layer 300 is provided on the side surface of the doped layer 200 away from the silicon substrate 100; and a plurality of grooves 400 are provided on a back surface of a back contact solar cell; positions where the grooves 400 are located do not include the passivation layer 300; and a central region 410 at a bottom of the groove 400 is provided with several first synaptic structures 510 connected to the doped layer 200. By forming the first synaptic structures 510 in the central region 410 at the bottom of the grooves 400, when metal grid lines are printed subsequently, a good ohmic contact can be formed between the metal grid lines and the first synaptic structures 510, thereby improving the carrier collection efficiency and improving the conversion efficiency of the cell.

The described content merely relates to preferred embodiments of the present disclosure, and is not intended to limit the present disclosure, and any modifications, equivalent replacements, improvements, etc. made within the spirit and principle of the present disclosure shall all fall within the scope of protection of the present disclosure.

## Claims

1. A back contact solar cell, comprising a silicon substrate, a doped layer and a passivation layer, wherein a back surface of the silicon substrate is provided with the doped layer; a side surface of the doped layer away from the silicon substrate is provided with the passivation layer; and a back surface of the back contact solar cell is provided with several grooves; positions where the grooves are located do not comprise the passivation layer; and a central region at a bottom of the groove is provided with several first synaptic structures connected to the doped layer.

2. The solar cell according to claim 1, wherein an edge region located at a periphery of the central region is provided at the bottom of the groove; and the edge region is provided with several second synaptic structures.

3. The solar cell according to claim 2, wherein the edge region is higher than the central region in a direction from the silicon substrate to the doped layer.

4. The solar cell according to any one of claims 1 to 3, wherein several first districts are provided in the central region; and at least some first synaptic structures at boundaries between adjacent first districts have a height higher than that of the first synaptic structures in the first district.

5. The solar cell according to claim 1, wherein the central region comprises a boundary of a tower base of a micro-pyramid structure; and at least some first synaptic structures at the boundary have a height higher than that of rest of the first synaptic structures.

6. The solar cell according to claim 2, wherein the edge region of the groove extends away from the central region to form a gap space between the doped layer and the passivation layer.

7. The solar cell according to claim 6, wherein a side surface of the passivation layer facing the gap space is provided with several third synaptic structures.

8. The solar cell according to claim 6 or 7, wherein several fourth synaptic structures are provided in the gap space; and two ends of the fourth synaptic structure are respectively connected to the doped layer and the passivation layer.

9. The solar cell according to claim 7, wherein shapes of the first synaptic structure, the second synaptic structure, and the third synaptic structure comprise at least one of a dome-shaped protrusion, a sharp tip, a spherical shape, a conical shape, and an irregular shape.

10. The solar cell according to claim 7, wherein a maximum distance between any two points on a bottom profile of the first synaptic structure, the second synaptic structure, and the third synaptic structure is less than 500 nm.

11. The solar cell according to claim 7, wherein heights of the first synaptic structure, the second synaptic structure, and the third synaptic structure are less than 500 nm.

12. The solar cell according to claim 1, wherein a diameter of the groove is 12 micrometers to 30 micrometers.

13. A photovoltaic module, comprising the solar cell according to any of claims 1 to 12.

14. A photovoltaic system, comprising the photovoltaic module according to claim 13.
